# EUROPEAN PATENT APPLICATION

(11) **EP 0 732 421 A1**
(43) Date of publication of application: **18.09.1996**
(21) Application number: 96301831.2
(22) Date of filing: 18.03.1996
(51) Int. Cl.: C23C 16/02, C23C 16/26, G21K 1/00

(54) **Method of making a graphite system**

(30) Priority: 17.03.1995 JP 58732/95
(71) Applicant: RESEARCH DEVELOPMENT CORPORATION OF JAPAN, Kawaguchi-shi, Saitama-ken 332 (JP)
(72) Inventor: Yudasaka, Masako, Kawasaki-shi, Kanagawa-ken (JP); Matsui, Takeo, Machida-shi, Tokyo (JP); Kikuchi, Rie, Yamato-shi, Kanagawa-ken (JP); Ohki, Yoshimasa, Sagamihara-shi, Kanagawa-ken (JP)
(74) Representative: Woods, Geoffrey Corlett

(57) **Abstract**

A process for producing a graphite crystal element suitable for an X-ray optical element comprises forming a graphite layer, by chemical vapour deposition, on a metal film which is disposed on a substrate having a glassy or crystalline surface. An X-ray optical element which comprises a graphite element obtainable by this process is also disclosed.

## Description

This invention relates a forming method of a graphite crystal element which is used for X-ray analysis, neutron spectrometric analysis, or for a radiation optical element necessary for these optical system referring to radiation ray. And also relates a X-ray optical element with use of the graphite crystal element formed by said method.

Optical element which is used for the X-ray optical equipments such as X-ray spectroscope, X-ray microscope and X-ray exposure scope utilizes subsidiary total reflection of X-ray which goes into by shallow angle of incidence, however, it mainly utilizes Bragg's reflection of crystal.

To utilize the Bragg's reflection, it is necessary that the crystal structures of optical crystal element is perfect, the crystal have a necessary size, the absorption to X-ray is small and can be processed to a necessary spherical or non-spherical shape. It is well-known that X-ray absorption of graphite is small and therefore graphite is a suitable material as a X-ray optical element. However, size of a natural graphite crystal is too small to have the necessary surface area. Therefore, efforts to obtain a crystal which has necessary size and crystal structure are executed, and consequently several kinds of artificial graphite crystal are put into practice.

For example, artificial graphite named CAPG (Compression-annealed pyrographite) has been started to be sold as a commodity from Union Carbide Co., Ltd. This artificial graphite is fabricated by annealing a high temperature thermal decomposition deposit of hydrocarbon at the temperature of 3600°C by compressive condition for a long period. And, highly crystallized graphite commodity named "Super graphite" obtained by thermal decomposition of thin film of polyoxadiazol or polyimide at temperature of 2800°C, is also sold from Matsushita Electric Co., Ltd. Referring to these mentioned manufacturing methods of graphite crystal, the treatment at high temperature and high pressure for a long period is required.

As above mentioned, according to the conventional manufacturing method of graphite crystal, it is necessary to compress the material at high temperature of 3000°C around. Therefore, as the facilities for graphite crystal manufacturing, not only a special and expensive ones is required but also running cost caused by electric energy and others raises. These factors rise the price of product, and the risen price prevent the wide application of the product.

Different from said prior arts, there are several disclosures to fabricate a thin film of graphite. For example, a technical method to fabricate a highly orientated graphite at lower temperature by using adequate material, is disclosed by the inventors (Japanese patent application H5-64946). The method is based on a method of chemical vapor deposition (CVD) on a substrate of crystallized metal such as nickel, cobalt, platinum or palladium. In this case, metals to be used must have a function as catalyst.

According to the CVD method the easily fabrication of graphite by lower price is possible, and it is necessary to use a metal which has a function of catalyst for the formation of graphite such as nickel, cobalt, platinum or palladium as a substrate. The coefficient of thermal expansion of said metals which are used as a substrate is about 1×10⁻⁵ level, but that of graphite is about l×10⁻⁶ level. And so the deposit thin layer of graphite is remarkably deformed by the effect of the difference of coefficient of thermal expansion during the cooling period to room temperature. Consequently, not withstanding a crystal structure of each crystal element is good, a total orientation of thin film is degraded, and have a defect that the full width at half maximum (FWHF) of X-ray rocking curve which indicates a grade of orientation of crystal element become a level of several degree of arc.

The inventors have conducted intensive study to form a highly orientated graphite at lower temperature by using CVD method. Consequently, following method of this invention is accomplished. That is, as a CVD substrate thin plate having small coefficient of thermal expansion on which surface thin nickel or other metal film is coated is prepared. And by depositing thin layer of graphite crystal on said thin metal film by CVD method, the highly orientated graphite crystal layer can be obtained. The object of this invention is to provide a forming method of highly orientated graphite crystal layer, a, also to provide a X-ray optical element with use of the grap ite layer formed by said method.

The coefficient of thermal expansion of the CVD substrate is typically from 5 x 10⁻⁷ to 9 x 10⁻⁶ (per °C). Suitable materials for the substrate include alumina, quartz and calcium fluoride.

Figure 1 is a longitudinal sectional view of graphite layer formed by the method of this invention.

Figure 2 is a cross sectional view of an example of chemical vapor deposit (CVD) apparatus of this invention.

Figure 3 is a cross sectional view of another example of chemical vapor deposit (CVD) apparatus of this invention.

Figure 4 is a cross sectional view of the other example showing the apparatus of chemical vapor deposition (CVD) of this invention.

Figure 5 is a chart of Raman scattering spectrum of the graphite thin layer obtained by Example 1.

Figure 6 is a chart of rocking curve of the graphite thin layer obtained by Example 1.

Figure 7 is a chart of rocking curve of the graphite thin layer arranged on nickel metal surface as comparative example.

Figure 8 is a longitudinal sectional view of another example of substrate used in this invention.

Figure 9 is an illustration of arrangement of optical parts of X-ray focusing mirror.

Figure 10 is an illustration of arrangement of optical parts of X-ray monochrometer.

In this invention, a plate made from glassy or crystallized material having small coefficient of thermal expansion on which surface thin film of nickel, platinum or palladium metal is arranged is used as a substrate for CVD method. Being influenced by a plate made from the material having small coefficient of expansion, deformation of metal thin film caused by thermal expansion is small, consequently strain caused by the difference of coefficient of thermal expansion between substrate and crystal layer is small and each crystal maintains it's original high orientation, and so the highly orientated graphite layer can be obtained.

The forming method of graphite layer of this invention will become apparent from the following description.

As the raw materials of graphite layer organic compound is used and there is no limitation for the selection of kinds of organic compound. Carbon monooxide, aliphatic or aromatic hydrocarbon such as methane, ethane, benzene, naphthalene or anthracene and other organic compounds can be generally used. However, in this invention, the use of 2-methyl-1,2'-naphthyl ketone and derivatives of it is desirable as the raw material. And, in this method, alumina, quartz or calcium fluoride is used as a substrate of glassy or crystallized material having small coefficient of thermal expansion and desirably single crystal of alumina is preferably used. There is no limitation to the thickness of the plate, and for example, a plate thicker than 0.3mm thickness is used. Metals which can be used as thin metal film are the preferred one selected from the group consisting of nickel, cobalt, platinum, palladium or alloy composed mainly of these metals which are considered to have a function of catalyst for CVD method. Desirable thickness of said metal thin layer is about from 10 to 500nm, and more desirably is 100nm around. If the thickness is thinner than 10nm, it agglomerates by itself and can not be used as thin film. As a method to arrange the thin metal film on a glassy or crystallized substrate, vacuum evaporation is generally used. It is very difficult to form a metal layer thicker than 500nm by this method, and any particular effect can not be expected to a graphite layer formed on the thicker metal layer.

In this invention, the desirable heat treatment condition for CVD method which forms deposit of graphite crystal layer on thin metal film is the temperature of lower than 1500°C, and more desirably the temperature of from 700 to 1000°C is preferred. And the desirable atmosphere is in non oxidation atmosphere of vacuum or lower than 210Pa pressure condition.

As aforementioned, if the metal thin film is too thin, it agglomerates by itself and can not be used as thin film, but this agglomeration can be prevented by arranging a carbon thin film under a thin film of catalyst metal thin film. The carbon thin film thicker than 0. 3nm is sufficient, and it is necessary to be strongly stuck to the insulating substrate enough to resist against the agglomeration power of evaporated metal. And accordingly, it is necessary that the temperature of the substrate during CVD process of carbon thin film is maintained at least at 300°C.

Thus, by forming a thin film of carbon on the surface of glassy or crystallized insulating substrate, even if a catalyst metal film is thinner than 10nm the agglomeration by raising of temperature is effectively prevented, consequently flat and homogeneous graphite crystal layer can be obtained.

The X-ray optical element of this invention will become apparent from the following description.

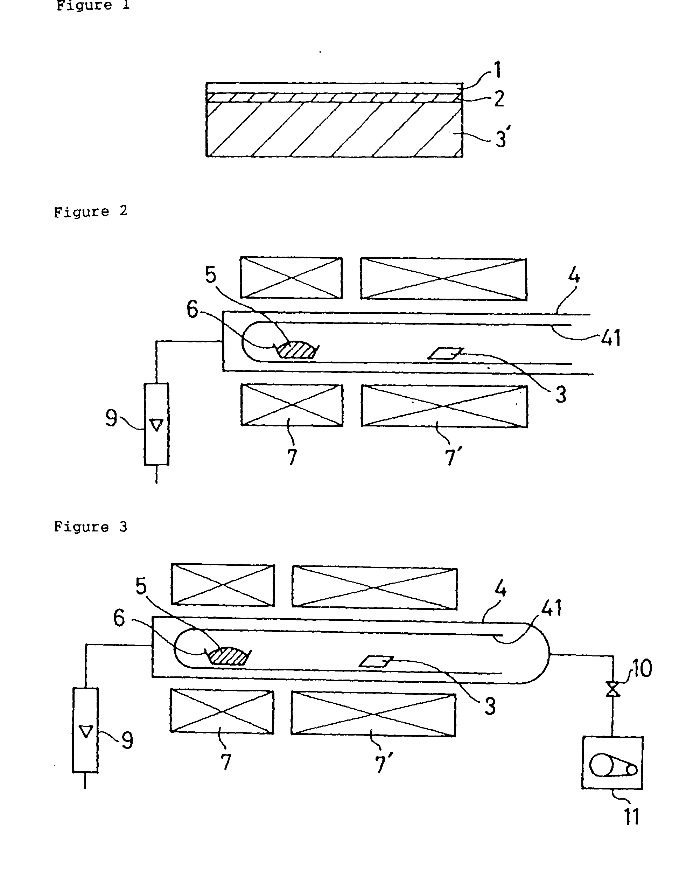

The laminated composite having graphite layer obtained by said forming method, is used as a X-ray optical element. In Figure 1, graphite crystal layer 1 is deposited and formed by CVD method on metal thin film 2 which is arranged on substrate 3 comprised of glassy or crystallized insulator.

Thickness of the graphite crystal layer applied as an optical element is depend on wave length of X-ray, but generally is thicker than 1µm. Since the graphite layer is characterized as highly orientated one, the X-ray optical element of this invention has a feature of high reflectivity. And, as a special feature of the X-ray optical element of this invention the possibility to form a X-ray optical element which has curved graphite crystal layer can be mentioned. That is, the raw material of substrate e.g. alumina which is used in this invention can be processed easily to the expected shape by grinding method. By using the substrate processed to a necessary shape, the graphite layer corresponded to the shape of substrate can be obtained. For example, if the substrate has a curved surface, the surface of thin metal film become to have a curved surface and consequently the surface of graphite crystal layer deposited on it becomes a curved one.

The X-ray optical element with use of said curved graphite layer can be used as a focusing mirror of excellent focusing ability.

The manufacturing condition of the X-ray optical element is almost same as to the mentioned manufacturing condition of graphite layer.

CVD apparatus which is used for the formation of graphite thin layer or X-ray optical element is illustrated by drawings. In Figure 1 a liner tube 41 is placed in a reactor tube 4 made of quartz and material 5 contained in a container 6 and a substrate 3 on which graphite layer must be deposited is placed in said liner tube separated from the container. The liner tube 41 is arranged to prevent sticking of deposit and deterioration of inner surface of reactor tube, and is changed to a clean one by each reaction. Temperature of raw material 5 placed in the liner tube 41 is regulated by an electric furnace 7 and control the generation of vapor volume. Temperature of the substrate 3 which is also placed in the liner tube 41 is regulated by an electric furnace 7'. One end of the reactor tube 4 is connected to a flow controller 9, which regulate the flow rate of inert gas when it is necessary to substitute reactor tube 4 with inert gas.

Figure 3 shows the another embodiment of an apparatus of CVD method. In Figure 3 one end of a reactor tube is connected to a flow controller 9, and another exhaust end is connected to a vacuum pump 11 through a needle valve 10 which controls exhaust rate. This apparatus is characterized as vacuum type CVD apparatus, and by using this apparatus a highly orientated graphite can be obtained.

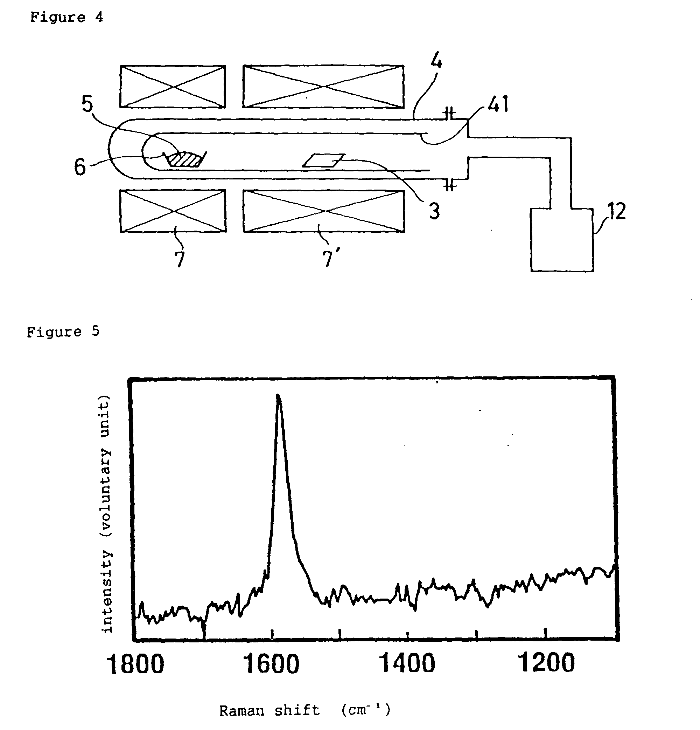

Figure 4 illustrates a vacuum type CVD apparatus. In Figure 4 one end of quartz reactor tube is closed and another end is connected to a high vacuum evacuating apparatus 12. Other points except the said point are similar to the apparatus illustrated by Figure 2. It is desirable to close reactor tube at the side in which material is placed. By using this apparatus highly orientated graphite can be obtained.

This invention will be definitely understood with reference to the following example.

### Example 1

Graphite thin film is formed with making use of an apparatus of CVD method illustrated by Figure 2. As the material 5 of CVD 2-methyl-1,2'-naphthylketone indicated by chemical formula 1 is prepared.

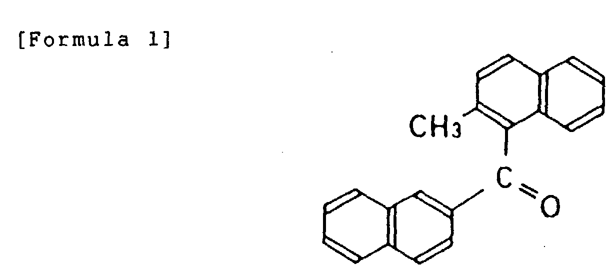

As the substrate 3 to form graphite thin film on it, a mirror finished alumina single crystal (0001) surface (c-surface)on which nickel layer of 100nm thickness is vacuum evaporated is prepared. Highly purified argon gas is supplied through flow controller 9 as the ambient gas to the reactor tube. The temperature of parts in which material 5 is placed is fixed to 400°C, argon gas is supplied to the reactor by flow rate of 300cc/min. After 5 hours, thin film of 1µm thickness which has mirror like surface with black and metallic lustre is deposited. The Raman scattering spectrum of the obtained thin film is measured, and the result is shown in Figure 5. It is clearly understood from the result that the spectrum of the obtained thin film indicates specific feature of crystallized graphite, and therefore, the obtained thin film is identified as the objected one.

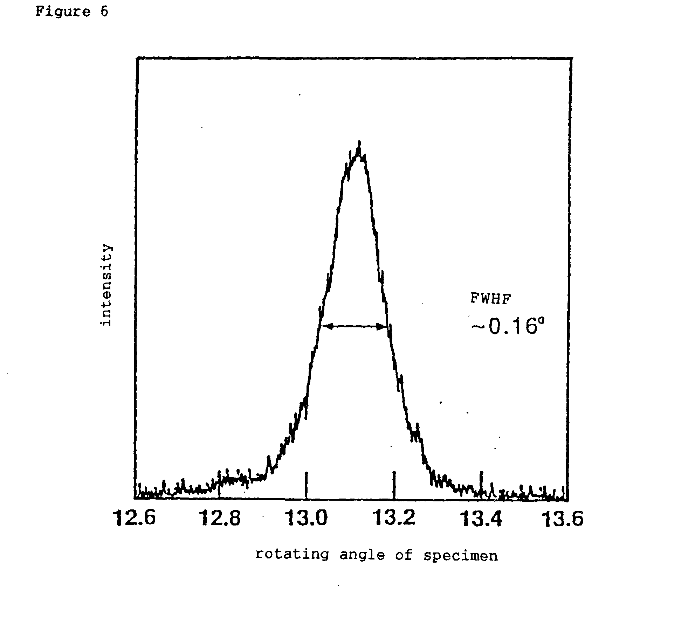

Said thin film is also analysed by X-ray diffractometer. The measurement of double crystal θ-2θ method to measure the spacing of lattice planes is used, and the result of spacing is 0.3354nm. This result is identified as the same value as the standard single crystal graphite. To investigate the orientation of crystallites which compose the thin film, X-ray locking curve is measured. The result is shown in Figure 6. As apparently shown in Figure 6 the full width at half maximum of diffraction peak is 0.16 degree and is recognized to be very narrow. This value is smaller than that of conventional product which is on market and indicates that the obtained thin film is highly orientated.

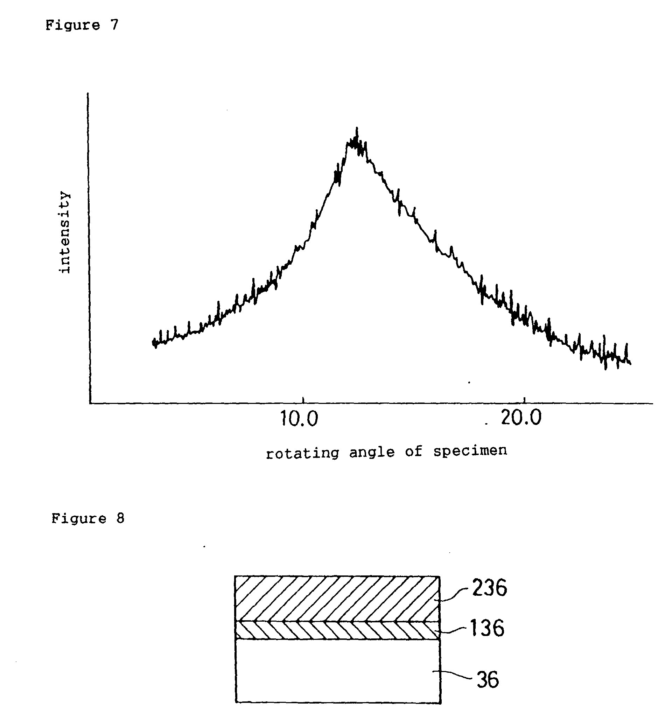

For the comparison, a nickel metal plate is used as a substrate. A graphite thin film is formed by using same CVD apparatus and same condition on said substrate and the X-ray rocking curve of obtained graphite thin film is measured. This result is shown in Figure 7 and it is clearly understood that the orientation of the obtained graphite film is low.

To recognize the influence of temperature of the part in which substrate is placed during CVD reaction, several test to vary the temperature is made. By the tests it is understood that the highly orientated graphite can be obtained at the temperature of higher than 600°C. That is, the formation of highly orientated graphite thin film at the temperature of lower than 600°C become possible by this invention which forms a graphite thin layer on insulating substrate on which catalyst metal thin film is vacuum evaporated.

The tests to recognize the influence of a kind of catalyst metal and thickness of it are executed and the results indicate that nickel, cobalt, platinum palladium or alloys composed by these metals is desirable to be used as a catalyst metal. And also the results indicate that the thickness of it is desirable to be thicker than 0.3nm as far as the metal film can exist as uniform film at the temperature of the substrate is placed. However, since too thin film have a tendency to agglomerate by itself at high temperature and can not maintain an uniform film state, for the practical use film of thicker than 10nm is desirable. And, if the metal layer is too thick, the effect of coefficient of thermal expansion of it become strong and highly orientated graphite can not be obtained. Therefore, for the practical use, the desirable thickness of film is thinner than 300nm.

### Example 2

A graphite thin layer is formed by CVD apparatus which is used in high vacuum condition as illustrated in Fig.4. Same material and same arrangements of the substrate to the Example 1 is used. That is, 2-methyl-1,2'-naphthylketone is used as material of CVD method, contained into container 6 and placed in liner tube. Amount of vapor generation of it is regulated by temperature of the electric furnace 7', A substrate which is used in this example is a mirror finished alumina single crystal (0001) surface (c-surface) on which nickel layer of 100nm thickness is vacuum evaporated. The open end of reactor 4 is connected to the high vacuum evacuating equipment 12. Inside of the reactor is evacuated, then the temperature of parts in which material 5 placed is fixed at 400°C and the temperature of substrate is fixed at 700°C. After 4 hours reaction by said condition, deposition of thin film of about 1 µm thickness having mirror like surface with black and metallic lustre is observed on the surface of the substrate. The Raman scattering spectrum of the obtained thin film is measured, and as the resultant spectrum which indicates the specific feature to a crystallized graphite is obtained as well as obtained in Example 1. Therefore, the obtained thin film is identified as the objected one. Furthermore, said thin film is also analysed by X-ray diffractometer, and it become clear that the thin film has the same spacing to single crystal graphite like to the thin film of Example 1. X-ray rocking curve is measured to investigate the orientation of crystallites which compose the thin film, and the full width of half maximum of diffraction peak value smaller than 0.2 degree is obtained. This value is recognized as very narrow and so the value indicates that the thin film is highly orientated.

As well as Example 1, temperature of the part in which substrate is placed during CVD reaction is varied and by the result it become clear that the highly orientated graphite can be obtained at the temperature higher than 600°C. The tests to recognize the influence of a kind of catalyst metal and thickness of it are executed and the results indicate that nickel, cobalt, platinum, palladium or alloys composed by these metals is desirable to be used as a catalyst metal. And also the results indicates that the thickness of it is desirably to be thicker than 0.3nm as far as the metal film can exist as uniform film at the temperature of the substrate is placed. However, since too thin film have a tendency to agglomerate by itself at high temperature and can not maintain an uniform film state, for the practical use film of thicker than 10nm is desirable. And, if the metal layer is too thick, the effect of coefficient of thermal expansion of it becomes strong and highly orientated graphite can not be obtained. Therefore, for the practical use, the desirable thickness of film is thinner than 300nm.

Thus, according to this Example, by the application of a method of chemical vapor deposition on an insulating substrate on which thin catalyst metal is evaporated, it become possible to obtain a highly orientated thin film of graphite at the temperature lower than 1000°C.

### Example 3

This example is an exemplar of CVD using a substrate having different structure.

Figure 8 is sectional view of a substrate which is used in one example of this invention. In the drawing, 36 is a substrate of (0001) surface of alumina single crystal, 136 is an amorphous or polycrystallized carbon thin film layer of lnm thickness deposited by CVD process at the temperature of 600°C and 236 is a platinum layer of 5nm thickness deposited by electron beam evaporation. By using the substrate having above mentioned structure, a thin layer of graphite is deposited by CVD method described in Example 1. After 5 hours depositing reaction, the deposition of uniform thin film of about 1µm thickness having mirror like surface with black and metallic lustre is observed. The Raman scattering spectrum of the obtained thin film is measured, and since the spectrum having specific feature of the crystallized graphite can be obtained. Therefore, the deposited thin layer is identified as an objected product. Furthermore, said thin film is also analysed by X-ray diffractometer, and the result of surface spacing of 0.3354nm is obtained. This result shows that the thin film is a standard single crystalline graphite. And also it is understood that highly orientated graphite is deposited because the full width of half rocking curve is narrow.

### Example 4

This example is an exemplar of CVD using a substrate which has curved surface like a partial surface of cylinder. That is, mirror finished substrate of alumina single crystal having curved surface like a partial surface of cylinder is prepared, and thin layer of platinum is evaporated on the surface. Same apparatus and same CVD condition as to Example 1 is applied. As the result, the highly orientated graphite thin layer is deposited along the curved surface of substrate as well as Example 1. According to the result of X-ray diffractometer, the obtained layer is a graphite layer having surface spacing of 0.3355nm and full width of half maximum of rocking curve of smaller than 0.5 degree (this value is affected by the curved surface of crystal).

By using alumina single crystal processed to have partial surface of sphere as substrate and same CVD condition, the deposition of highly orientated graphite layer is observed. Furthermore, by using same procedure, it become possible to deposit highly orientated graphite thin layer over the surface of voluntary shape.

It is apparent from Example 1 and 2 that highly orientated graphite can be obtained both by CVD of low pressure condition or CVD of vacuum condition.

According to this Example, by using a substrate processed by precision processing, the hexagonal net work orientated graphite can be formed on the surface.

### Example 5

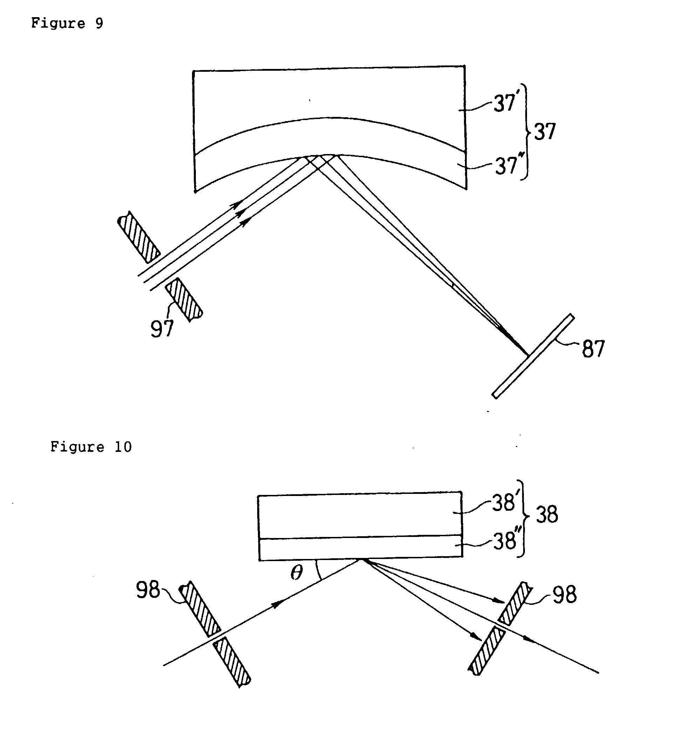

Fig. 9 is an illustration of a focusing mirror using graphite thin layer having cylindrical surface obtained by Example 4. Thin layer of platinum is evaporated on alumina single crystal of 15mm×15mm size of which surface is processed by grinding so as to have concave surface like a part of cylinder, and performs a substrate 37'. A mirror 37 comprised graphite layer 37" deposited on a substrate 37' is prepared. Through a small hole of lmm bored into Mo plate 97 Cu Kα-ray is led to the mirror 37. The image on photo plate which is placed on focusing point is a thin line of about lmm length and about 20µm width, and indicates good focusing ability.

In this Example, the example of cylindrical mirror formed on concave surface is disclosed. By this invention it become possible to fabricate the mirror having various shape such as spherical or non-spherical surface.

According to this Example, by using precision processed substrate, it become possible to form the X-ray optical element which has necessary shape and focusing ability.

### Example 6

Fig.10 is an illustration of monochrometor 38 comprised of graphite layer 38" formed on flat substrate 38'. By changing a installation angle θ of monochrometor 38, it is possible to disperse the X-ray passed through a pin hole bored in one Mo plate 98. By making the X-ray pass through a pin hole bored in another Mo plate 98', the X-ray can be monochromated. Ka ray of Cu is led and installation angle is fixed at θ=13.288°, the obtained line width of X-ray is 0.2°.

According to this Experiment, the precise X-ray monochrometor can be easily fabricated.

As the result of the research of the inventors to form a catalyst metal thin film on insulator substance, it is eventually found that the highly orientated graphite layer can be formed on said substrate by comparative lower temperature. And the precise X-ray optical element can be easily fabricated with making use of mentioned graphite layer.

## Claims

1. A process for producing a graphite crystal element, which process comprises forming a graphite layer, by chemical vapour deposition, on a metal film which is disposed on a substrate, having a glassy or crystalline surface.

2. A process according to claim 1 which further comprises forming a carbon layer of more than 0.3 nm thickness on the surface of the substrate before disposing the metal film on the substrate.

3. A process according to claim 1 or 2 wherein the metal film is selected from platinum, nickel, cobalt, palladium and alloys thereof.

4. A process according to any one of the preceding claims wherein the chemical vapour deposition is conducted using an organic material at a temperature of lower than 1500°C.

5. A process according to any one of the preceding claims which is conducted in a non-oxidising atmosphere.

6. A process according to any one of the preceding claims which is conducted in a vacuum or at a pressure lower than 210 Pa.

7. A process according to any one of the preceding claims wherein the substrate material comprises alumina, quartz or calcium fluoride.

8. An X-ray optical element which comprises a graphite layer obtainable by a process as defined in any one of the preceding claims.

9. An element according to claim 8 wherein the substrate has a curved surface along which the graphite layer is formed.

10. A focusing mirror which comprises an element as claimed in claim 9.
